Europäisches Patentamt

European Patent Office

Office européen des brevets

(19)

(11) Publication number: **0 171 343**
A1

# EUROPEAN PATENT APPLICATION

(12)

(21) Application number: 85630075.1

(22) Date of filing: 02.05.85

(51) Int. Cl.⁴: **C 30 B 11/14**, C 30 B 29/52

(30) Priority: **11.05.84 US 609909**

(43) Date of publication of application: **12.02.86 Bulletin 86/7**

(84) Designated Contracting States: **DE FR GB**

(71) Applicant: **UNITED TECHNOLOGIES CORPORATION, United Technologies Building 1, Financial Plaza, Hartford, CT 06101 (US)**

(72) Inventor: **Giamei, Anthony Francis, 54 Virginia Drive, Middletown Connecticut 06457 (US)**
Inventor: **Anderson, Neal Paul, 99 Tumblebrook Drive, South Windsor Connecticut 06074 (US)**
Inventor: **Salkeld, Richard Walter, 48 Clover Drive, South Windsor Connecticut 06074 (US)**

(74) Representative: **Schmitz, Jean-Marie et al, Office Dennemeyer S.à.r.l. 21-25 Allée Scheffer P.O. Box 41, L-2010 Luxembourg (LU)**

(54) **Polygon cross section seed for directional solidification.**

(57) In the directional solidification of single crystal castings the seed crystal (90) is specially fit within the starter section (92) of the mold (93) to minimize angular rotation to less than 0.6 degrees.

Preferably the seed (90) is polygon shaped in cross section and has planar sides.

EP 0 171 343 A1

Polygon Cross Section Seed for
Directional Solidification

Technical Field

The invention relates to the field of metal
casting, more particularly to the directional
solidification of single crystal structures using a
seed crystal.

Background

As described in the co-pending application
Serial No. 333,600 filed December 23, 1981, certain
large metal castings are successfully made by using
multiple seeds.  In such instances it is important
to critically align the crystallographic axes of the
structure growing from each seed, both with respect
to the growth axis (called "primary orientation") and
with respect to the plane transverse thereto (called
"secondary orientation").  Also, it is important
that accurate orientations be achieved in single
crystal parts which have improved performance due
to controlled secondary orientation, as described
in the application of Gemma et al, Serial No. 330,757
filed December 14, 1981.

In the past seeds have been typically round in
cross section.  Patent No. 4,412,577 to Salkeld et
al and having common ownership herewith discloses a
typical cylindrical seed and teaches that the seed
must fit closely in the mold starter portion to
avoid liquid metal flowing into a gap between the

-2-  0171343

periphery of the seed and the interior of the mold. Controlled secondary orientation has been suggested as being attainable with round seeds, by polarizing both the seed and the ceramic mold with respect to the chill plate on which they mount. See UK Patent No. GB 2 037 200 of United Technologies Corporation, where the seed is keyed to the chill plate. However, such conventional techniques have been found to be costly or to not easily give the requisite accuracy because of cumulative errors.

Disclosure of the Invention

An object of the invention is to simply orient a seed with respect to the article section of a mold, to enable precise control over the crystallographic orientation of a casting. A further object is to enable castings to readily be made from multiple seed crystals.

In a preferred embodiment of the invention a polyhedron shape seed is made to closely fit within the starter section of the ceramic mold to a close tolerance and less than 0.6 degrees of angular rotation is permitted. In a more general manifestation of the invention, the seed will have a cross section shape which is comprised of at least one straight line. The straight line will be a manifestation of a planar surface transverse to the cross section, which planar surface will closely abut a mating planar surface of the mold and thereby control the rotation of the seed with respect to the mold and the article formed therein. The preferred seed is polygon shape in cross section and has planar sides; in a simple embodiment the seed is a square cross section polyhedron. In another embodiment of the invention the seed may be recessed into a pocket on the chill plate.

The preferred practice seed fits within the starter cavity of the mold to a tolerance sufficiently close to limit the angular rotation to 0.2-0.6 degrees; this corresponds with a linear tolerance of 0.003-0.010 mm/mm between the mating cross section lines of the seed and mold. The close fit referred to is that which is attained when the seed and mold are at their highest temperatures encountered during the casting process, to account for the characteristic greater thermal expansion coefficient of the metal seed compared to the ceramic mold. For example, the close tolerance fit in the x-y plane is that which is attained at the uppermost part of a seed which rests on a horizontal chill plate. Based on the physical properties of the materials used, the room temperature fit which is necessary can be calculated and produced.

The invention is particularly useful in the casting of superalloy parts in single crystal form, but will be pertinent to other castings and materials. While the invention is described in terms of the use of an open ended mold on a chill plate, the principles of the invention will be applicable to other casting situations where different mold configurations are used. The invention eliminates the need for independently polarizing the mold and seed. Thus, greater accuracies of crystallographic orientation in the desired cast article are attainable.

The foregoing and other objects, features and advantages of the present invention will become more apparent from the following description of preferred embodiments and accompanying drawings.

Brief Description of the Drawing

Figure 1 shows in an exploded view a ceramic mold, a chill plate, and a seed which is captured within the mold when it rests on the chill plate surface.

Figure 2 shows a semi-cylindrical seed which has a planar surface and which can be used in the practice of the invention.

Figure 3 shows how a seed like that used in the Figure 1 apparatus is recessed into a pocket on the chill plate.

Best Mode for Carrying Out the Invention

The disclosure of the allowed copending application Serial No. 333,600 of Giamei, filed December 23, 1981, is hereby incorporated by reference. The co-pending application, made by a common inventor herewith, generally describes how directionally

0171343

solidified castings are made and how large castings are made with two or more seeds. The disclosures of U.S. Patent Nos. 4,209,348, 3,494,709, 3,542,120, 3,700,023, 4,412,577 and 4,190,094 are also incorporated by reference. These patents teach the making of single crystal parts by directional solidification and describe the face centered cubic superalloy which is preferably used in the making of single crystal gas turbine engine parts and the present invention.

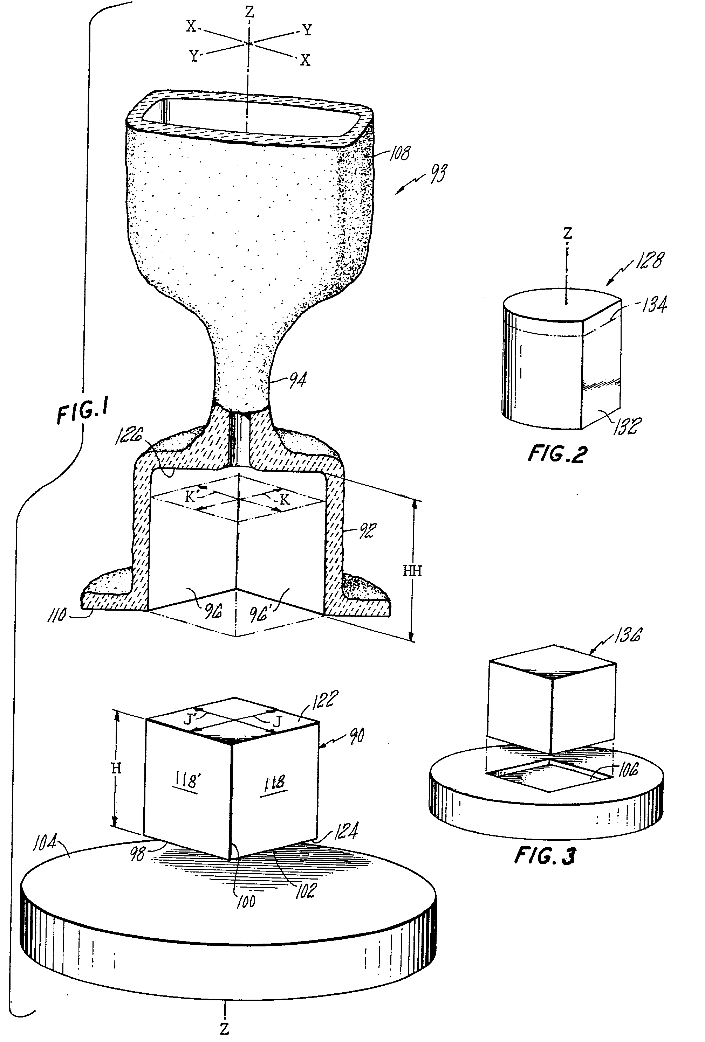

Figure 1 shows in exploded view the parts of the invention which enable precise alignment of a seed with respect to a mold. The mold 93 is comprised of an article section 108 connected by a selector section 94 to a flanged and open ended starter section 92. The flange 110 of the starter section is adapted to mate with the upper surface of the chill plate 104 and to be held thereagainst, such as by clamps or the like which are not shown. The seed rests directly on the surface of the chill plate 104. The seed has a z axis height H and an orthogonal x-y cross section with square edge lengths J, J'. The typical vertexes or edges 98, 100, 102 of the polyhedron seed were previously aligned with respect to the crystallographic axes of the metal which comprises the single crystal of the seed. This is done by measuring and marking the crystal orientation using known x-ray diffraction or substitutional techniques prior to conventional machining.

The mold is made of a conventional ceramic material typical of directional solidification investment casting molds. The interior of the starter section 92 of the mold is made to carefully correspond with and receive the seed. Specifically, the x-y cross section shape and dimensions K, K' where the seed locates in the mold (as shown in phantom) are carefully chosen to be congruent with the dimensions J, J' of the seed. They are chosen so that when the mold and seed rise to their highest temperature, usually that experienced just prior to the introduction to molten metal into the mold, the mating fit between the interior of the mold starter and the seed 90 will reflect a certain close tolerance mating fit. Specifically, the mating fit permitted between the seed and the starter ought to be less than that which permits an angular motion between opposing z axis planes of 0.010 mm/mm, preferably less than 0.005 mm/mm. The indicated close mating fit will limit the angular rotation of the seed in the x-y plane about the z axis to 0.3-0.6 degrees. For other polygonal cross section shapes than the square shown in Figure 1, the relative dimensions of the starter part of the mold and the seed will be made to achieve a similar result. This close mating fit is not arbitrary, but is based on the metallurgical criticalities set forth in the referenced Giamei and Gemma et al applications. There will be of course some inevitable dimensional error in the making of the seed (e.g., in the machining of the seed and the measuring of the crystallographic axes' orientation) and in the making of the mold, so that the article section corresponds with the starter section. Thus, when the seed is more loosely toleranced in the mold than indicated, the quality and utility of the directionally solidified product will vary and can be inferior. The close fit herein may be viewed in light of a radial fit of 0.06-0.25 mm taught for a cylindrical seed according to the Salkeld et al U.S. Patent No. 4,412,577. But of course the patent was not concerned with angular orientation, but with non-epitaxial growth.

Since on heating the seed typically expands a greater amount than the mold, the mating fit to be achieved in the x-y plane at the temperature of fabrication will be looser than that indicated and must be calculated. As an example, zircon and alumina based ceramic molds have thermal expansion coefficients in the range 4-11 x $10^{-6} °C^{-1}$ while gas turbine nickel superalloys have coefficients in the range of 10-17 x $10^{-6} °C^{-1}$ and melting points greater than 1200°C. Inasmuch as the seed necessarily is heated to the melting point at its uppermost surface, there will be substantial relative dimensional change between the seed and mold on heating from room temperature. These changes can be readily calculated with limited experiment and the requisite room temperature dimensions calculated. The mold and seed are made to the room temperature dimensions using known techniques. The mold article section 108 is of course in an appropriately defined spatial orientation with the seed-receiving starter section. It will thus be appreciated that upon heating of the mold to the temperature of casting there will be a close and definable alignment between the seed in the x-y plane and both the starter and article sections.

Similarly, the seed will be oriented with respect to vertical z planes by controlling the fit along the length H of the seed, i.e., the fit between the typical seed vertical planes 118, 118' and typical starter section interior surface planes opposing the planes 96, 96'. There is a complicating variable in that, while the top surface of the seed 90 must be at the melting point of the metal, i.e., above 1200°C, prior to the beginning of the directional solidification process, there will then be a z axis temperature gradient in the mold and the seed, owing to the cool chill plate. Because of the differential thermal expansion of the seed and mold, there will be an inherent variation in fit along the length of the seed, meaning the actual variance will be greater than the hypothetical isothermal tolerance. While it is possible to compensate for this in the shaping of the seed and starter cavity it is satisfactory to choose to make the vertical height H

0171343

of the seed sufficient to lower the angle of possible movement in the mold to within the desired range indicated above. As a practical matter we preferably calculate the nominal mating z plane fit based on the average temperature of the seed/mold. In the best practice of our invention the 0.3-0.6 degree rotation is obtained in all x, y and z planes. However, it is oftentimes sufficient to very closely control only motion with respect to two axes, because of the acceptability of the resolved error that results in combination with the less closely controlled other axis.

While we prefer a polyhedron shape seed, the upper and lower ends 122, 124 need not be planar although best results require there be good heat transfer contact of the lower end 124 with the chill plate. There is a necessary relationship between the seed height H and the starter cavity height HH; HH is chosen to be larger than H to allow accumulation of molten cast metal poured into the mold, which metal helps melt the seed fully and disrupt surface films. The seed height H also should be sufficient to ensure that at least 25 percent of the seed is able to be melted prior to beginning the casting cycle. The shape of the top 126 of the starter cavity is important and is usually preferably nearly perpendicular to the z axis. We prefer a relatively simple quadrilateral polygon cross section, i.e., a rectangle or square, but other polygonal shapes will carry out the practice of the invention. Similarly, while the simplest embodiment is a seed with a constant z axis polygonal cross section, progressively smaller sections (i.e., a tapered seed and starter) will carry out the invention as well. Also, planar sides are preferred for simplicity but curvilinear sides are substitutional within the principles of the invention. Analogously, the seed 128 shown in Figure 2 has a generally cylindrical shape but has a planar surface 132 which polarizes the seed with respect to a mating mold starter section cavity. In our broadest invention, the seed (and mold starter section) has a z-direction planar surface, so that there is defined in the x-y cross sectional plane of the seed at least one straight line, such as 134 in Figure 2. And the fit along that straight line limits rotation to 0.3-0.6 degrees of rotation in the preferred use.

It should be appreciated now that the seed and mold of our invention will self-align. Thus there is no need to polarize the mold and seed individually to the chill plate as has been done in the past. Nonetheless, as shown in Figure 3, a seed 136 may fit in a chill plate pocket 106, which would thereby polarize the apparatus with respect to the chill plate, when this is desired. The fit between the seed and its receiving pocket 106 will be characteristic of a loose slip fit as such a fit is known in the machining trade.

Although this invention has been shown and described with respect to a preferred embodiment, it

0171343

will be understood by those skilled in the art that various changes in form and detail thereof may be made without departing from the spirit and scope of • the claimed invention.

0171343

We claim:

1. Apparatus for directional solidification from a seed of a cast part having global x, y and z axes from molten metal contained in a mold having corresponding axes, wherein solidification takes place along the z axis, characterized by a mold having a starter section with an x-y plane cross section shape which is comprised of at least one straight line and a congruent shaped cross section seed positioned within the starter section; the mating fit between the seed and the starter section causing the seed to be closely aligned with respect to the global axes of the part during directional soldification of the casting.

2. The apparatus of claim 1 wherein the mold starter section and seed have congruent polygon shaped cross sections and planar sides.

3. The apparatus of claim 1 characterized by a starter section which has a quadrilateral polygon cross section starter.

4. The apparatus of claim 3 characterized by a seed which is square in cross section.

5. The apparatus of claim 1 characterized in that the mating fit allows less than 0.6 degrees of angular

0171343

movement of the seed in the x-y plane with respect to the global x-y axes of the mold when the seed and starter section are at elevated temperatures characteristic of the highest they are exposed to during the directional solidification process.

6. The apparatus of claim 2 characterized in that the mating fit allows less than 0.6 degrees of angular movement of the seed in the x-y plane with respect to the global x-y axes of the part when the seed and starter section are at elevated temperatures characteristic of the highest they are exposed to during the directional solidification process.

7. The apparatus of claim 5 wherein the mating fit allows less than 0.6 degrees of angular movement of the seed with respect to the x, y and z global axes.

8. The apparatus of claim 6 wherein the mating fit allows less than 0.6 degrees of angular movement of the seed with respect to the x, y and z global axes.

9. The apparatus of claim 5 wherein there is allowed about 0.2 degrees of angular movement.

10. A mold for the directional solidification of a single crystal structure cast part from a seed contained in a starter section part of the mold characterized by the starter section having a polygonal cross section shape.

11. The mold of claim 5 characterized by a quadrilateral polygon cross section shape starter section.

1/1

0171343

FIG.1

FIG.2

FIG.3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A,D | US-A-4 412 577  (R.W. SALKELD) | | C 30 B  11/14<br>C 30 B  29/52 |
| | --- | | |
| A | FR-A-2 444 092  (UNITED TECHNOLOGIES) | | |
| | ----- | | |

TECHNICAL FIELDS
SEARCHED (Int. Cl.4)

C 30 B  11/14
C 30 B  29/52

The present search report has been drawn up for all claims

| Place of search<br>THE HAGUE | Date of completion of the search<br>22-08-1985 | Examiner<br>BRACKE P.P.J.L. |
|---|---|---|

EPO Form 1503. 03.82